Europäisches Patentamt

European Patent Office

Office européen des brevets

(19)

(11) Publication number: **0 171 129**
A2

# EUROPEAN PATENT APPLICATION

(21) Application number: **85301031.2**

(22) Date of filing: **15.02.85**

(51) Int. Cl.⁴: **C 25 D 5/02, H 01 L 21/288**

(30) Priority: **17.02.84 US 581499**

(43) Date of publication of application: **12.02.86**
**Bulletin 86/7**

(84) Designated Contracting States: **BE CH DE FR GB IT LI LU NL SE**

(71) Applicant: **ENERGY CONVERSION DEVICES, INC., 1675 West Maple Road, Troy Michigan 48084 (US)**

(72) Inventor: **Nath, Prem., 245 Prospect, Rochester Michigan 48063 (US)**
Inventor: **Barnard, Timothy J., 702 Kimberly, Apt. 201, Lake Orion Michigan 48035 (US)**
Inventor: **Crea, Dominic., 37880 Moravian, Mt. Clemens Michigan 48043 (US)**

(74) Representative: **Jackson, Peter Arthur et al, GILL JENNINGS & EVERY 53-64 Chancery Lane, London WC2A 1HN (GB)**

(54) Method of electro-coating a semiconductor device.

(57) A non-destructive method of electro-coating a preselected pattern of electrically insulating or conducting material onto a semiconductor device which includes a photoresponsive junction. The method includes the step of illuminating the semiconductor device prior to initiating the flow of electro-coating current. The method has particular utility in providing electroplated grid patterns and connections on large-area photovoltaic cells.

0171129

ENERGY CONVERSION DEVICES, INC.     Ref: 50/2592/02

METHOD OF ELECTRO-COATING A SEMICONDUCTOR DEVICE

In the fabrication of relatively large area photovoltaic devices, it is often desirable to include a relatively high conductivity metallic grid pattern upon the light incident surface of the device. This grid pattern provides a low resistance current path for the collection of photogenerated current decreasing the internal resistance of the photovoltaic device and increasing its efficiency. Likewise, other semiconductor devices require a patterned layer of electrically conducting or insulating material to define or interconnect regions or to form contact points on the device.

Known methods of depositing patterned layers on semiconductor devices include vacuum deposition through a mask, including etching, printing of conducting or insulating inks, electroless plating and electroplating. In electroplating an electrical field applied to an immersed surface reduces an ionic species initially in solution causing that species to plate out of the solution and form a deposited layer on the surface being coated.

Electroplating techniques are gaining acceptance as a method of depositing electrically conductive layers in the preparation of semiconductor devices. For example, see U.S. Patent Application Serial No. 524,797 of Prem Nath, et al., filed August 19, 1983 and entitled Method of Forming An Electrically Conductive Member, which discloses a method for electroplating an electrically conductive pattern onto a transparent conductive oxide layer of a semiconductor device such as a photovoltaic cell.

In addition, U.S. Patents 4,144,139 to Durkee and 4,251,327 to Grenon disclose various techniques for electroplating a metal on a semiconductor body containing a p-n junction. In the patent to Durkee, light is directed at the device while it is immersed in a electrolyte. The photovoltage produced provides the necessary energy for the plating process. The patent to Grenon discloses use of the photovoltage to power a plating process on the illuminated surface of a semiconductor body while an external voltage source independently powers a plating process on the reverse side of the semiconductor body.

- 2 -    0171129

In all the electroplating processes an electrical current must pass through the semiconductor material to effect the plating. However, the flow of the relatively large plating current through the layers of semiconductor material at the relatively high voltages needed to initiate the plating process can damage those layers. The problem is aggravated with semiconductor devices constructed of very thin layers that have an inherently large lateral resistance. The lateral resistance causes an inadequate flow of plating current to the portions of the surface of the semiconductor body that are relatively distant from the electrode connected to the body. As a result, the plated material varies in thickness from a relatively thick layer proximate the semiconductor electrode to a relatively thin layer on areas distant from the electrode.

Accordingly, there is a need for a process for electroplating a metallic pattern on a semiconductor body containing a photoresponsive junction in which the semiconductor is protected from damage induced by the plating current and which produces relatively uniformly thick deposits in spite of the lateral resistance effects of thin layers. These problems are solved in the invention by immersing a semiconductor body containing a photoresponsive junction in a electrolyte, illuminating the body through the surface to be plated in order to activate the photoresponsive junction, and providing an electrical current from an external source to an unilluminated surface of the semiconductor device and to the electrolyte. Under illumination, the photoresponsive junction allows a relatively unimpeded flow of current through the semiconductor body. Electrically conductive and/or insulating patterns may be formed on a surface of the semiconductor device by (1) utilizing a resist pattern to restrict the areas in which the electroplating process can occur; (2) electroplating a continuous layer upon a surface of the device, the layer being subsequently etched to provide the shape of the desired pattern, or (3) projecting the illumination in a preselected pattern, corresponding to the pattern to be electroplated, onto the device while it is immersed in the electrolyte. Insulating coatings such as oxides and nitrides, as well as conductive coatings, such as metals, may be deposited on semiconductor bodies containing a p-n junction by utilizing the inventive electro-coating process.

Figure 1 is a fragmentary, cross-sectional view of a tandem photovoltaic cell comprising a plurality of p-i-n type cells.

Figure 2 is a fragmentary plan view of a large-area photovoltaic device comprising a plurality of small-area isolated cells, each of which includes an electrically conductive grid pattern.

Figure 3 is a schematic representation of apparatus for electro-coating a preselected pattern on a semiconductor body.

Figure 4A is a graph of current versus voltage showing the electrical characteristics of an unilluminated semiconductor junction such as the p-i-n junction of the photovoltaic cell depicted in Figure 1.

Figure 4B is a graph of current versus voltage showing the electrical characteristics of a semiconductor junction, such as the p-i-n junction of the photovoltaic cell depicted in Figure 1, at two different intensities of illumination.

Figure 5A is a perspective view of apparatus for continuously electro-coating a preselected pattern on an elongated web of semiconductor devices.

Figure 5B is a schematic front elevational view, in cross section, of the electro-coating station of the apparatus of Figure 5A.

Figures 6A, 6B, 6C, 6D, and 6E are fragmentary, cross-sectional views of a semiconductor body having electro-coated thereon, according to invention, a continuous homogeneous layer, a discontinuous homogeneous layer, a continuous heterogeneous layer, a discontinuous layer with homogeneous and heterogeneous regions, and a discontinuous heterogeneous layer, respectively.

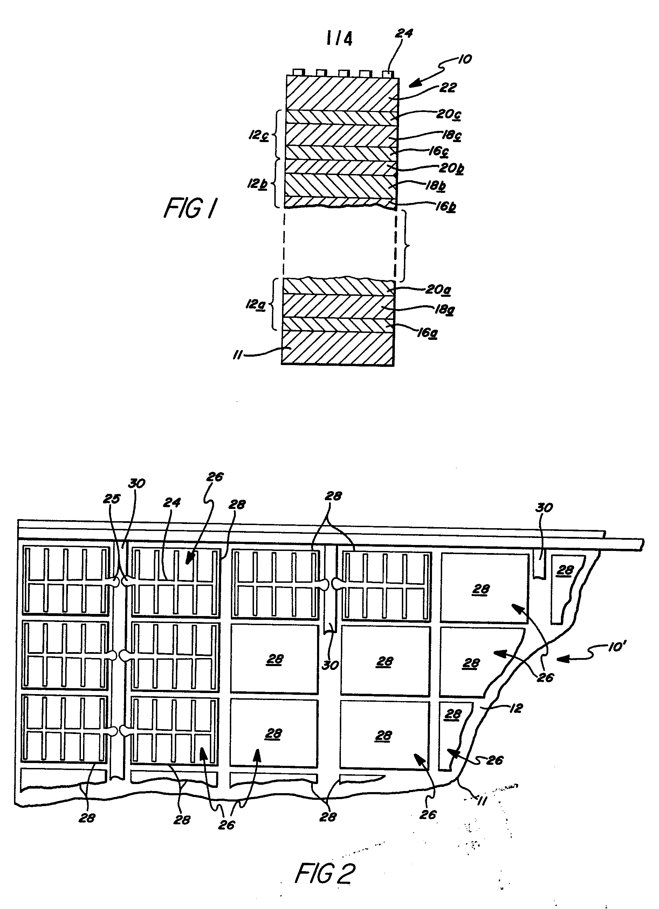

Figure 1 shows a p-i-n type photovoltaic device 10, such as a solar cell, composed of individual p-i-n type cells 12a, 12b and 12c. A substrate 11 disposed on cell 12a forms a second surface of cell 10 and functions as one of its electrodes. Substrate 11 may be transparent or may be formed from a metallic material such as stainless steel, aluminum, tantalum, molybdenum or chromium, with or without an insulating layer thereon.

Each of cells 12a, 12b and 12c are preferably fabricated from an amorphous semiconductor body containing at least a silicon or germanium alloy. Typically the layers in such cells prepared of amorphous semiconductor alloys are no more than several hundred nanometers thick. Each cell includes an n-type conductivity semiconductor layer 20a, 20b and 20c; an intrinsic semiconductor layer 18a, 18b and 18c; and a p-type conductivity semiconductor layer 16a, 16b and 16c. As illustrated, additional cells intermediate cells 12a and 12c may be added.

A layer 22, which may be a transparent conductive oxide, preferably indium tin oxide, forms an electrode on the first surface of device 10. A metallic grid pattern 24 may be applied to layer 22 if device 10 covers a large area or if the conductivity of layer 22 is insufficient.

Figure 2A is a fragmentary plan view of a large-area photovoltaic device 10' generally similar to device 10 of Figure 1. Device 10' includes a continuous, large-area substrate 11 bearing a continuous layer of semiconductor material 12 formed into a plurality of electrically isolated portions 26, that each contribute to the total electrical output of device 10'. Isolated portions 26 share the common substrate 11 and are each overlaid with a discrete region 28 of a transparent conductive oxide material that has been deposited on the semiconductor material 12. Each of discrete regions 28 functions as an electrode of an individual small-area photovoltaic cell. A current collection grid 24 is deposited on each segment. Each grid 24 is connected to a system of busbars 30 for collection of the photogenerated currents. Grids 24 are connected to busbars 30 by connectors 25 which may be spots of silver paste. Busbars 30, connectors 25 and grids 24 are preferably fabricated of a material having a relatively high electrical conductivity such as a metallic material.



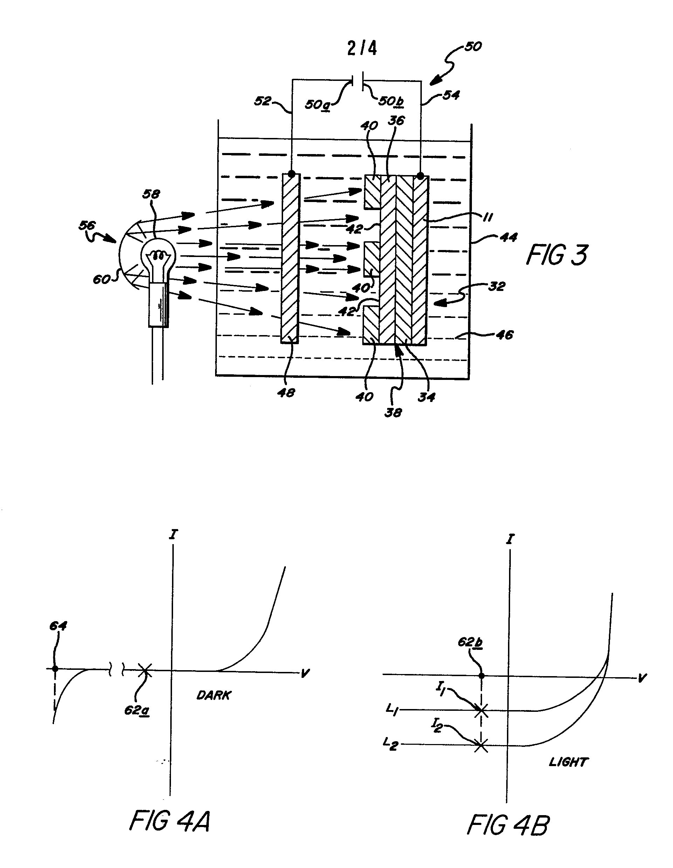

A semiconductor device 32 is depicted in Figure 3 as a p-n junction device, but is representative of any photoresponsive device such as a diode, a photovoltaic cell, a light emitting diode, etc. that incorporates a photoresponsive junction. Semiconductor device 32 includes a substrate layer 11 formed of an electrically conductive material such as stainless steel, a layer of p-type conductivity semiconductor material 34 disposed on substrate 11, and a layer of n-type conductivity semiconductor material 36 disposed on and generally coextensive with p-type semiconductor material 34. The p-type and n-type semiconductor layers form a p-n junction 38 at their interface. Layer 36 forms the light-receiving or first surface of device 32 on which has been deposited a preselected pattern 40 of electroplating resist material. Resist material pattern 40 defines non-resist coated regions 42 upon which metallic material is electroplated to form the electrically conductive pattern. Electroplating resist material pattern 40 may be formed by any of various known techniques such as screen printing, offset printing, stenciling, photolithography, etc. and is preferably formed by depositing materials such as lacquer, synthetic resins, and the like. One material having particular utility for the formation of an electroplating resist pattern is MacuMask 9251-M manufactured by the McDermid Corporation. Alternatively, the entire first surface of device 32 may be electroplated, and selected regions 42 of the coating subsequently removed by masking and etching, or some other like method, for fashioning the desired pattern.

Device 32 and a second or counter-electrode 48 are immersed in a suitable vessel 44 containing an electrolyte 46. The composition of electrolyte 46 and counter-electrode 48 depends on the particular material being electro-coated onto the semiconductor device 32. One terminal 50a of a source of electrical current, such as a battery 50, is connected to counter-electrode 48 via a wire 52, while the other terminal 50b of battery 50 is directly connected via a wire 54 to substrate 11. Substrate 11 forms the second surface of device 32.

A light source 56 is depicted in Figure 3 as a lamp, such as a quartz halogen lamp 58, and a reflective shield 60 for directing the radiation from lamp 58 toward the first surface of semiconductor device 32. Light source 56 must be capable of producing wavelengths of light that will be absorbed in semiconductor device 32 to create carrier pairs in the region of photoresponsive junction 38. It is these carrier pairs that permit semiconductor device 32 to pass the electro-coating electrical current without being degraded or destroyed.

Light must reach photoresponsive junction 38 to generate carrier pairs. If semiconductor device 32 is illuminated from the first side, a growing deposit can "shade" the underlying junction, decreasing the rate of electroplating. This self-limitation is generally not a problem if the deposit is relatively transparent, the deposit is formed in a pattern using a relatively transparent resist or device 32 is illuminated from the second side.

Figures 4A and 4B depict typical current-voltage curves for an idealized photoresponsive junction. Figure 4A generally illustrates the behavior of a photovoltaic junction in the dark. At a nominal reverse bias voltage (indicated by numeral $62\underline{a}$ in Figure 4A) required for an electroplating process to proceed in such a semiconductor device, virtually no electrical current will flow and electroplating will proceed at a negligible rate, if at all. In order to initiate a sufficient flow of electrical current for electroplating to proceed, a relatively large reverse bias voltage, having at least the magnitude indicated by the numeral 64, must be impressed across the device. However, a voltage of such magnitude will degrade or destroy the semiconductor material of the semiconductor device being electroplated.

Figure 4B depicts current-voltage curves of the same photoresponsive junction under varying intensities of illumination. Both of the current-voltage curves are shifted downward by an amount directly related to the amount of illumination incident upon the photoresponsive junction. Curve $L_1$ is indicative of the current-voltage characteristics of the photoresponsive junction at a first level of illumination and curve $L_2$ is indicative of the current-voltage characteristics of the same junction under more intense illumination. At the voltage required for electroplating, indicated by the numeral 62b, the curve indicative of the first level of illumination, $L_1$, shows a current $I_1$ flows through the photoresponsive junction, and the curve indicative of the second level of illumination, $L_2$, shows a greater current $I_2$ flowing through the photoresponsive junction. In this manner, the amount of electrical current flowing in the electroplating process is controllable by controlling the intensity of illumination incident on the surface being electroplated. Most importantly, the illumination permits sufficient electrical current to pass through the junction of a semiconductor device to enable the electroplating process to proceed effectively and efficiently at the necessary voltage level without damaging the semiconductor device. In addition, by illuminating the portions of the first surface of the device remote from its connection to the external power source, plating current flow is encouraged compensating for the lateral resistance of the thin semiconductor layers.

The process depicted in Figure 3, is described as an electroplating process, but other processes, such as anodization, can be practiced by a similar method in which only the composition of the electrolyte and the polarity of the electrical current flowing through the semiconductor device is modified. The term electro-coating is therefore used here to describe all such coating processes.

A pattern may be electro-coated on a semiconductor material by use of a light projection process, rather than through masking and coating or coating and etching processes. Light shown through a mask may be projected onto the surface of the device and electrical current will preferentially flow through the illuminated regions. An electro-coated deposit will form on the illuminated areas of the device. The projection technique may be employed with an externally applied electro-coating current or in a self-energized process.

The projection technique may be used to form an initial pattern that serves as a nucleation pattern for subsequently deposited material. In such a case, a first relatively thin patterned layer is formed while projecting an image, as previously described, on the substrate. The patterned illumination is terminated in favor of uniform illumination and electro-coating is continued.

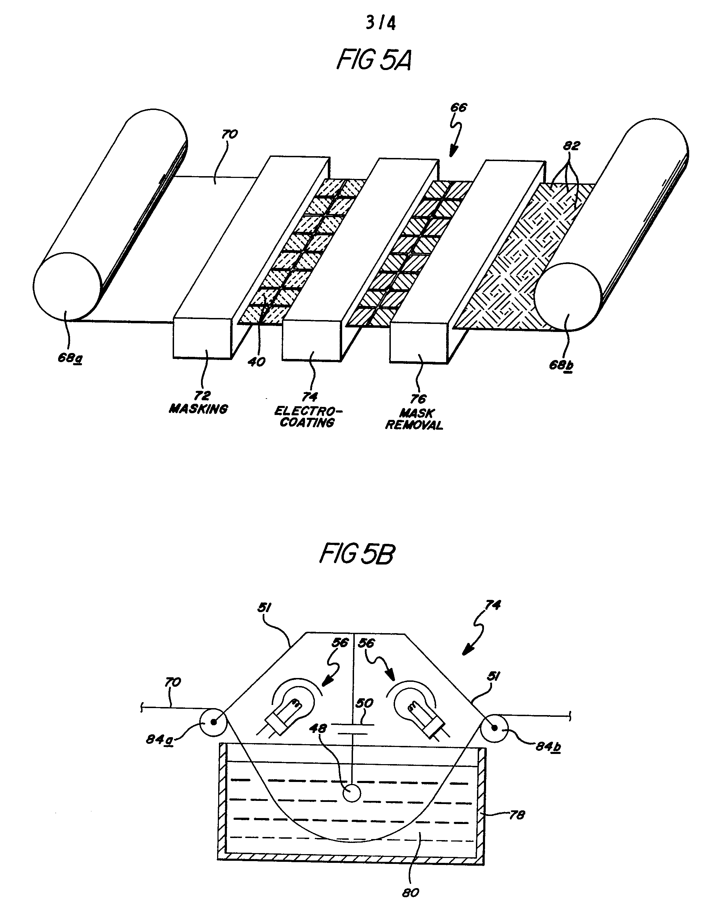

The invention may be used in a continuous process apparatus such as apparatus 66 shown in Figure 5A. Apparatus 66 includes a supply roller 68a about which a continuous web 70 of the semiconductor devices to be coated are wound, a take-up roller 68b about which the coated web is wound, a mask application station 72, an electro-coating station 74 and a mask removal station 76. Web 70 is continuously advanced from supply roller 68a to mask application station 72 where a resist pattern 40 is applied by any of the conventional processes previously described. Patterned web 70 is advanced to electro-coating station 74 where the unmasked portions of the web are electro-coated.

Figure 5B depicts a preferred embodiment of electro-coating station 74 including a tank 78 containing an electrolyte solution 80. Web 70 is guided through solution 80 by a pair of guide rollers 84a, 84b, although other guide means such as magnets could be utilized. Guide rollers 84a and 84b are electrically connected via wires 51 to a power source, such as a battery 50, to provide an electrical contact to the back surface of the web. Sliding electrical contacts may also be used. The electrical circuit is completed by an electrode 48 immersed in solution 80. Electro-coating station 74 also includes one or more sources of illumination 56 to activate a photoresponsive junction within web 70 of semiconductor devices. The illumination must be of a wavelength and intensity to activate the junction for passage of the electro-coating current without harming the devices and to deposit a desired thickness of material as the web passes through electro-coating station 74. The amount of electrical current flowing through the semiconductor devices formed on web 70 is dependent upon the intensity and wavelength of the illumination and the external power supplied to the web. The thickness of the electro-coated deposit depends upon the amount of current flowing through the device and the transit time of web 70 through electro-coating station 74. Thus, by choosing the proper combination of illumination, power and web speed, the thickness of the electro-coated deposit may be controlled.

After leaving plating station 74, web 70 is advanced to mask removal station 76 for the removal of the resist pattern to leave electro-coated pattern 82 on the surface of the web. Station 76 may comprise, for example, a tank of solvent through which web 70 continuously passes. After removal of the mask, the patterned web of semiconductor devices is wound about take-up roll 68b for storage or further processing.

Alternatively, web 70 may be patterned by an image projected in positional registration on the moving web as it passes through electro-coating station 74. Or the entire first surface of the web 70 may be electro-coated and the pattern formed by subsequent masking and etching steps.

Figures 6A-6E illustrate, in diagrammatic form, various possible applications of the inventive method. Figure 6A depicts a semiconductor device 86 having a continuous, homogeneous layer 88 deposited on its exposed surface. The term "continuous" refers to a layer, such as 88, which is generally coextensive with the upper surface of device 86, i.e., covers substantially the entire surface of device 86 without gaps, breaks or voids. Homogeneous layer 88 may be a layer of electrically conductive material, semiconductor material, or insulating material and may comprise a single element or be a compound of two or more elements. The structure depicted in Figure 6B is generally similar to that shown in Figure 6A, except the homogeneous layer is discontinuous, including a plurality of segments 88a and 88b. The term "discontinuous" refers to a layer of electro-coated material which does not extend across the entire exposed surface of semiconductor device 86, but includes uncoated regions 90.

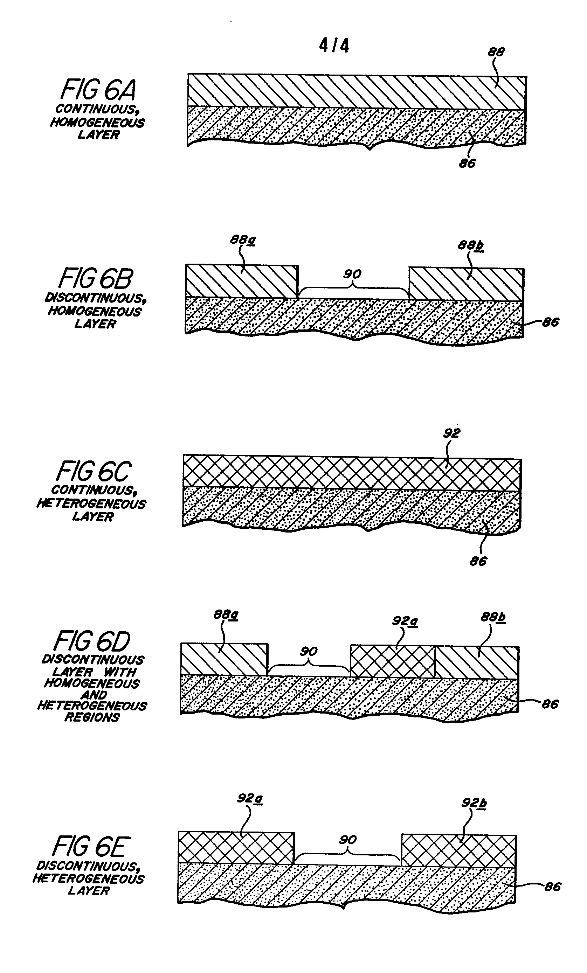

Figure 6C depicts a typical semiconductor device 86 having a continuous heterogeneous layer of electro-coated material deposited on its exposed surface. As used herein "heterogeneous" refers to a material having a composition that varies spatially. Figure 6E is generally similar to Figure 6C, except that it depicts a discontinuous heterogeneous layer having a plurality of regions 92a and 92b lying on either side of uncoated regions 90.

Depicted in Figure 6D is a discontinuous layer of electrodeposited material having homogeneous regions 88a and 88b, as well as heterogeneous regions, such as 92a, deposited on semiconductor device 86. As in Figures 6B, and 6E, electro-coated regions 88a, 88b and 92a define uncoated regions 90 on the exposed surface of semiconductor device 86.

## EXAMPLE 1

Nickel was electroplated in a preselected pattern on an exposed indium tin oxide surface of an amorphous silicon alloy p-i-n photovoltaic device generally similar to the cell shown in Figure 1. The exposed indium tin oxide surface was cleaned, rinsed in deionized water and electrical contact was made to the stainless steel substrate layer by cementing a wire to the substrate with a spot of electrically conductive epoxy adhesive. The photovoltaic device was then immersed into a mild (approximately 10%) sulfamic acid solution for 5 seconds and thereafter placed in a nickel sulfamate plating bath which was maintained at a temperature of approximately 50°C with a pH of approximately 4. The nickel sulfamate bath is a commercially available product supplied by the Allied-Kelite Division of the Witco Chemical Company. A 200 watt tungsten filament lamp was positioned outside the plating bath, at a distance of approximately 10 cm from the photovoltaic device to illuminate the light incident surface of the device during the plating operation. An electrical current of approximately .1 amperes at a bias of approximately -1 volt was applied to the 25 square centimeter sample device, thus providing an effective current density of 10 milliamps per square centimeter. The current flowed through the device for approximately one minute producing an electroplated nickel layer having good adhesion, good electrical conductivity, a smooth surface and a thickness of approximately .2 micrometers. No damage occurred to the cells of the photovoltaic device during the plating process.

## EXAMPLE 2

Copper was electroplated in a preselected pattern on an exposed indium tin oxide surface of a p-i-n photovoltaic device generally similar to the cell shown in Example 1. The device was cleaned, rinsed, electrically connected to an electrical current source, and immersed into a sulfamic acid solution as in the foregoing example. After the sulfamic acid immersion, the photovoltaic device was dipped into a copper sulfate plating bath, and illuminated as in Example 1. The copper sulfate plating bath, supplied by the Allied-Kelite Division of the Witco Chemical Company, was maintained at room temperature with a pH of approximately 1. An electrical current of approximately .1 amperes at a bias of -1 volts was passed through the bath. The sample again was about 25 square centimeters in area, and developed a current density of approximately 10 milliamps per square centimeter. The electrical current flowed through the photovoltaic device for 1 minute and produced an electroplated layer of approximately .2 microns thickness. The copper-plated layer exhibited good adhesion, high electrical conductivity and a smooth surface. Again, no damage to the cells of the photovoltaic device occurred.

- 12 -

0171129

## EXAMPLE 3

In this example an electrically conductive multi-layer sandwich was deposited in a preselected pattern upon each exposed surface of electrically isolated indium tin oxide segments of a large-area photovoltaic device, generally similar to the photovoltaic device depicted in Figure 2. The large-area photovoltaic device first had a resist pattern deposited onto the exposed surface of the indium tin oxide defining areas corresponding to a grid pattern. After applying the resist-coating layer, the device was washed with a mild detergent, rinsed, had an electrical contact affixed to the common electrically conductive substrate and was dipped in sufamic acid (as in the previous two examples). The prepared device was then placed in a nickel sulfamate electroplating bath maintained at 40°C, with a pH of approximately 4, and illuminated as in the foregoing examples. A current of 25 milliamps at -1 volt bias was passed through the photovoltaic device for approximately one minute, resulting in a current density of 15 milliamps per square centimeter flowing through the unmasked portions of the device. The flow of current and the illumination were terminated, the sample was rinsed in deionized water and then immersed in a copper sulfate plating bath which was maintained at room temperature and a pH of approximately 1. The photovoltaic device was again illuminated and an electrical current of 25 milliamps at -.25 volts bias was passed through the device for one minute. The current and the illumination were terminated, the sample was rinsed in deionized water, then reimmersed in the previously used nickel sufamate batch, and reilluminated. At a bias of -1 volts, a current of 25 milliamps flowed through the device for one minute. The device was disconnected from the source of electrical current, rinsed and dried. The resulting tri-layer nickel-copper-nickel grid pattern deposited upon the exposed indium tin oxide surface of the photovoltaic device exhibited good adhesion, high electrical conductivity and presented a smooth surface. As with the previous examples, the small-area photovoltaic cells of the large-area photovoltaic device were not harmed.

EXAMPLE 4

In this example, a pattern was anodized on an iron electrode layer previously deposited on a single amorphous silicon p-i-n device. The device was cleaned by washing with acetone, and a resist pattern was applied on the exposed surface of the iron electrode layer by utilizing MacuMask 9251-M manufactured by the McDermid Corporation. The non-resist-covered portion of the surface defined the regions of the iron electrode to be anodized. The resist-coated device was immersed for 10 minutes into an aqueous solution of .5 molar $FeCl_3$ and maintained at 50°C. The device was then placed in an oxidizing bath of 10% $CrO_3$ in water at room temperature and illuminated by a 500 W tungsten-halogen lamp positioned approximately 5 cm from the device. An anodization current of 50 milliamps was provided to the device for 30 minutes, and resulted in a coating current density of approximately 20 milliamps per $cm^2$ flowing through the unmasked portions of the p-n junction device. Once anodization was complete, illumination was terminated, electrical current was terminated and the device was removed from the electrolyte and rinsed. This treatment resulted in the formation of a 2.0 micrometer thick coating of iron oxide on the unmasked portions of the device.

Other materials such as gold, silver, chromium or the like and similar oxide coatings, nitride coatings and the like may be electrocoated on anodically semiconductor layers according to the invention.

0171129

CLAIMS

1. A method of electro-coating a material on first surface (42) of a semiconductor device (32) having opposed first (42) and second surfaces and including a photoresponsive junction (38) disposed between said first and second surfaces, including immersing said semiconductor device (32) in an electrolyte (46) and illuminating said first surface to activate said junction (38), characterized in connecting an external electrical current source between said second surface and said bath, said activated photoresponsive junction providing for the flow of electrical current from said second surface to the first surface (42) without damage to said device.

2. The method of claim 1 characterized by electroplating said material upon the first surface of said semiconductor device.

3. The method of claim 1 characterized by anodically oxidizing said first surface of said semiconductor device so as to form an oxidized pattern thereupon.

4. The method of claim 1 characterized in electro-coating a plurality of successively deposited layers.

5. The method of claim 1 characterized in depositing a non-continuous electro-coating resist layer (40) on said first surface (42) to define a pre-selected pattern for receiving an electro-coated deposit.

6. The method of claim 1 characterized in, after electro-coating said first surface, depositing an etchant resist layer on portions of said electro-coating that correspond to a preselected electro-coated pattern and etching said electro-coating in the areas not covered by said etchant resistant layer.

7. The method of claim 1 wherein said semiconductor device (32) is disposed on an elongated web of substrate material (70), said web forming said second surface, characterized by continuously advancing said elongated web through said electrolyte (80) to electro-coat said semiconductor device in a thickness proportional to the transit time of said web (70) through said electrolyte.

8.    The method of claim 1 characterized in controlling the thickness of said electro-coating by controlling the intensity and duration of said illumination of the semiconductor device (32).

9.    The method of claim 1 characterized in illuminating only portions of said first surface (42) in an image of a preselected pattern on said first surface (42) for depositing a patterned electro-coated deposit on said first surface (42).

10.    The method of claim 9 wherein said semiconductor device is disposed on an elongated web of substrate material (70), said web forming said second surface characterized in continuously advancing said elongated web (70) through said electrolyte (80) and maintaining said image in registration with said advancing web.

FIG 1

FIG 2

0171129

FIG 3

FIG 4A

FIG 4B

*FIG 5A*

70   66   82

68a

40

68b

72
MASKING

74
ELECTRO-
COATING

76
MASK
REMOVAL

*FIG 5B*

51   56   56   74

70   50

48   51

84a   84b

78

80

*FIG 6A*
CONTINUOUS,
HOMOGENEOUS
LAYER

88

86

*FIG 6B*
DISCONTINUOUS,
HOMOGENEOUS
LAYER

88a

88b

90

86

*FIG 6C*
CONTINUOUS,
HETEROGENEOUS
LAYER

92

86

*FIG 6D*
DISCONTINUOUS
LAYER WITH
HOMOGENEOUS
AND
HETEROGENEOUS
REGIONS

88a

92a

88b

90

86

*FIG 6E*
DISCONTINUOUS,
HETEROGENEOUS
LAYER

92a

92b

90

86